# EUROPEAN PATENT APPLICATION

(11) **EP 4 093 159 A1**
(43) Date of publication of application: **23.11.2022**
(21) Application number: 21191650.7
(22) Date of filing: 17.08.2021
(51) Int. Cl.: H05K 1/11, H05K 1/14, H05K 3/34, H05K 3/36

(54) **PREPARATION METHOD FOR CONNECTOR, ELECTRONIC DEVICE, CONNECTOR AND APPLICATION THEREOF**

(30) Priority: 18.05.2021 CN 202110539799
(71) Applicant: Focalcrest Limited, 518000 Shenzhen Guangdong (CN)
(72) Inventor: XIE, Wenjie, Shenzhen (CN)
(74) Representative: Monteiro Alves, Inês

(57) **Abstract**

A preparation method for a connector, an electronic device, a connector and an application thereof. The preparation method comprising: step 100: preparing a PCB having a shape matched with the shape and structure of functional boards needing to be connected, and forming via holes in the PCB, wherein the via holes correspond to the positions of soldering pads of the functional boards; step 200: preparing soldering pads for connecting the functional boards on the PCB, wherein the soldering pads are arranged in the via holes for communicating the functional boards on both sides of the PCB. The present invention provides a connector using a PCB as a carrier. The connector can be prepared into any desired shapes. The number of pins is large and the occupied area is small. Through designing the soldering pads and the spacing, a stable high-speed signal transmission is achieved. The elements are allowed to be arranged on both sides of the PCB such that the cost is greatly lowered.

## Description

### TECHNICAL FIELD

This invention generally relates to the technical field of connectors, and more particularly, to a preparation method for a connector, an electronic device, a connector and an application thereof.

### BACKGROUND

Presently, a board-to-board connector between PCBs uses plastic as the support and metal strips or metal sheets as pins to connect PCBs.

The pins of a connector are normally arranged into forms such as straight single-row or straight double-row. These arrangements affect the design space and the layout of PCBs, resulting in high production cost. Although two PCBs can be connected using a cost-efficient board-edge half-hole connection method, the elements are merely allowed to be arranged on one side of the connector. As a result, the area of the connector and the parasitic parameter are large, severely affecting the transmission of high-speed signals.

Therefore, it is urgent for those skilled in the art to solve the technical problems in the prior art.

### SUMMARY

The purpose of the present invention is to provide a preparation method for a connector, an electronic device, a connector and an application thereof.

A preparation method for a connector of the present invention, comprising the steps of:
Preparing a PCB (Printed Circuit Board) having a shape matched with the shape and structure of functional boards needing to be connected, and forming via holes in the PCB, wherein the via holes correspond to the positions of soldering pads of the functional boards.

Preparing soldering pads for connecting the functional boards on the PCB, wherein the soldering pads are arranged in the via holes for communicating the functional boards on both sides of the PCB.

In another aspect of the present invention, preparing a PCB having a shape matched with the shape and structure of the functional boards needing to be connected, comprising: hollowing-out a PCB, thereby allowing the PCB to match or accommodate the elements on the functional boards.

In another aspect of the present invention, the preparation method further comprising: using a PCB design software to simulate the parametric model of a PCB and then prepare a real PCB.

In another aspect of the present invention, the present invention provides an application of a PCB connector using the connector prepared through adopting the preparation method of the present invention.

In another aspect of the present invention, the connector is a board-to-board connector.

A PCB connector, comprising: a connector main body, wherein the connector main body is a PCB, wherein a plurality of via holes are formed in the PCB, soldering pads are arranged in the via holes, and the soldering pads are used for communicating the two functional boards.

In another aspect of the present invention, the PCB is provided with a space for accommodating the elements on the functional boards.

An electronic device, comprising: a first functional board, a second functional board and the aforesaid connector, wherein the soldering pads on both sides of the connector are respectively connected with the soldering pad of the first functional board and the soldering pad of the second functional board.

In another aspect of the present invention, the soldering pads on both sides of the connector are respectively connected with the soldering pad of the first functional board and the soldering pad of the second functional board by means of the surface mounting technology.

A preparation method for a connector of the present invention, comprising: preparing a PCB having a desired shape, and forming via holes in the PCB; preparing soldering pads for connecting the functional boards on the PCB, wherein the soldering pads are arranged in the via holes for communicating two functional boards.

Compared with the prior art, the present invention has the following advantages:
The present invention provides a connector using a PCB as a carrier. The connector can be prepared into any desired shapes. The number of pins is large and the occupied area is small. Through designing the soldering pads and the spacing, a stable high-speed signal transmission is achieved. The elements are allowed to be arranged on both sides of the PCB such that the cost is greatly lowered.

### BRIEF DESCRIPTION OF THE DRAWINGS

Figure 1 is a flow chart illustrating a preparation method for a connector of an embodiment of the present invention
Figure 2 is a conceptual diagram illustrating an exemplary structure of a connector of an embodiment of the present invention.
Figure 3 is a conceptual diagram illustrating a state after the two functional boards are connected with the connector.
Figure 4 is a conceptual diagram illustrating an explosive view of Figure 3.
Figure 5 is a flow chart illustrating a preparation method for another connector of an embodiment of the present invention.
Figure 6 is a conceptual diagram illustrating a sectional view of a connector of the present invention.
Figure 7 is a structural diagram illustrating a preparation method for a connector of an embodiment of the present invention.
Figure 8 is a conceptual diagram illustrating a state after the soldering pads of a connector are connected with the soldering pads of two functional boards of an embodiment of the present invention.

In the Figures:
1-The First Functional Board, 2-Connector, 3-The Second Functional Board, 4-Element, 5-PCB, 6-Via Hole, 7-Soldering Pad, 8-Space, 9-PCBA1 Soldering Pad, 10-PCBA2 Soldering Pad, 11-Tin Solder.

### DETAILED DESCRIPTION

Drawings in the embodiments are combined hereinafter to clearly and completely describe the techniques of the present invention. Obviously, the described embodiments are merely a representative part but not all of the embodiments of the present invention. The specification of the present invention allows those skilled in the art to obtain other embodiments without paying creative labor, and thus all of which shall fall into the scope of the present invention.

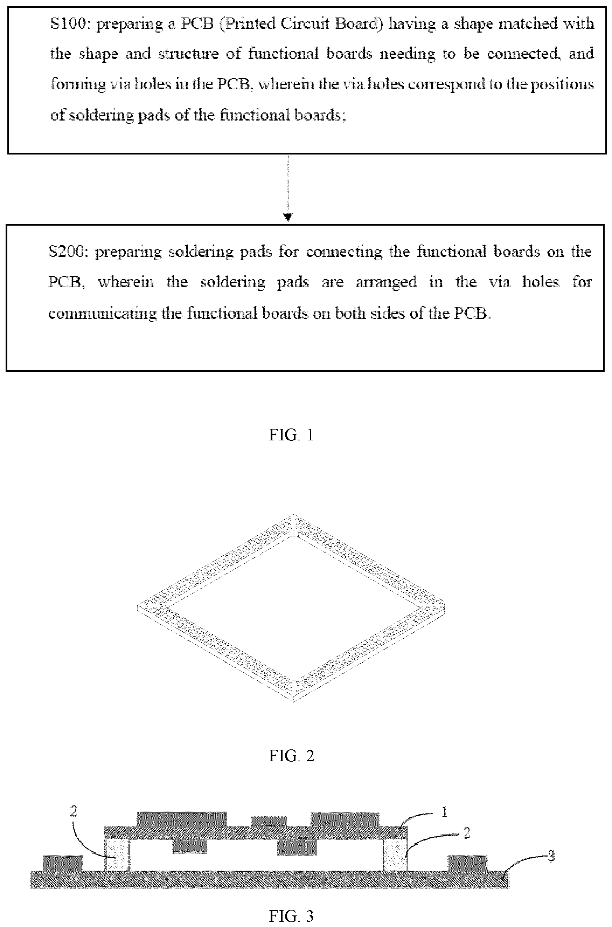

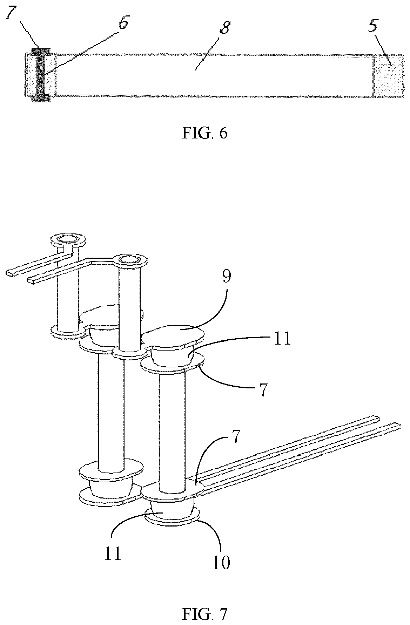

Figure 1 is a conceptual diagram illustrating a preparation method for a connector of the present invention. It can be understood in conjunction with Figures 6 and 7. A preparation method for a connector of the present invention, comprising the steps of:
Step 100: preparing a PCB (Printed Circuit Board) having a shape matched with the shape and structure of functional boards needing to be connected, and forming via holes in the PCB, wherein the via holes correspond to the positions of soldering pads of the functional boards.

For instance, the pins of the PCB can be arranged into single-row, double-row or ring-shaped. As everyone knows, the process of preparing PCBs has been a mature technology. Presently, the PCB of a connector can even be prepared together with the PCB of a functional board to be connected.

Because connecting pins are needed by the connector, it is necessary to prepare connecting pins on the PCB. Via holes are formed in the PCB, and the via holes are arranged to correspond to the positions of the pins of the functional boards to be connected, namely, the soldering pads.

Step 200: preparing soldering pads for connecting the functional boards on the PCB, wherein the soldering pads are arranged in the via holes for communicating the functional boards on both sides of the PCB.

In this embodiment, soldering pads are prepared on both sides of the PCB for respectively connecting the two functional boards needing to be connected, and the soldering pads are located in the via holes. A plurality of via holes are formed to correspond to a plurality of soldering pads, and the plurality of soldering pads are prepared to correspond to the connecting pins.

The present invention provides a connector using a PCB having a certain structure as a carrier. The shape of the connector can be customized according to the shape of the PCB to be connected. The pins of the connector can be arranged into any desired forms such as single-row, double-row or three-row. The number of pins is large and the occupied area is small. Through designing the soldering pads and the spacing, a stable high-speed signal transmission is achieved. Moreover, the elements are allowed to be arranged on both sides of the PCB instead of being wholly arranged on one side of the PCB. By means of this design, the size of the PCB is significantly reduced and the cost is greatly lowered. The production cost of the connector of the present invention is much lower than that of a conventional connector.

Further, more specifically, preparing a PCB having a shape matched with the shape and structure of the functional boards needing to be connected, comprising: hollowing-out a PCB, thereby allowing the PCB to match or accommodate the elements on the functional boards.

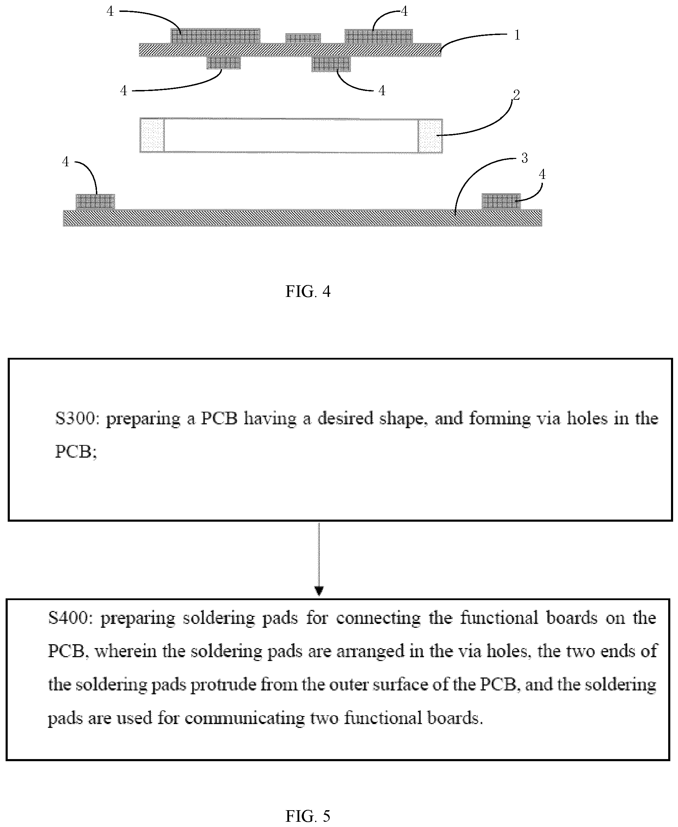

As shown in Figure 2, the connector is a square PCB connector. Via holes and soldering pads are arranged around the connector, wherein the middle portion of the connector is removed for allowing the elements on the functional boards soldered to the both sides of the connector to pass through or be accommodated. Specifically, Figures 3-4 are conceptual diagrams illustrating the connection of the functional boards, wherein Figure 3 is a conceptual diagram illustrating a structure after the two functional boards 1 and 3 are connected with the connector 2, and Figure 4 is a conceptual diagram illustrating an explosive view of Figure 3. The functional boards are provided with elements 4.

Definitely, in other embodiments, the hollowing-out process of the connector can be replaced by a slotting process.

In another embodiment of the present invention, when preparing a PCB, a PCB design software may be adopted to simulate the parametric model of a PCB and then prepare a real PCB.

For instance, using a PCB design software to draw a two-layered PCB to be used as a PCB connector. The PCB connector is merely provided with soldering pads and via holes. The design and production of a connector are the same as that of a PCB, and the prepared connector is actually a PCB capable of being directly used as a connector.

Through adopting the PCB design software, the size and spacing of the soldering pads of the connector can be designed to affect the attenuation degree of signals. Meanwhile, different parameters can be adjusted according to the signal type. By lowering the parasitic parameter, the parametric model can be simulated to prepare a real PCB connector. In some experiments, the connector of the present invention allows 8Gbps high-speed rate signals to pass through. In the prior art, due to the influence of the size and material, only special high-speed connectors are capable of allowing the high-speed signals to stably pass through.

As shown in Figure 5, the present invention also provides a preparation method for a connector. A preparation method for a connector of the present invention, comprising the steps of:
Step 300: preparing a PCB with a desired shape, and forming via holes in the PCB;
Step 400: preparing soldering pads for connecting the functional boards on the PCB, wherein the soldering pads are arranged in the via holes, and the soldering pads are used for communicating the two functional boards.

Figure 6 is a conceptual diagram illustrating a sectional view of the connector of the present invention. Figure 7 is a structural diagram illustrating the preparation method for the connector of the present invention. The PCB connector prepared by using the aforesaid method comprises a connector main body, wherein the connector main body is a PCB (Printed Circuit Board) 5, wherein a plurality of via holes 6 are formed in the PCB 5, soldering pads 7 are arranged in the via holes 6 (actually, soldering pads are also arranged on the right side of Figure 6 but they are omitted for convenience of marking), and the soldering pads 7 are used for communicating the two functional boards.

As shown in Figure 7, a PCBA1 (Printed Circuit Board Assembly 1) soldering pad 9 is arranged at the bottom of the PCBA1, and the connector 2 is mounted on the PCBA1 by means of the surface mounting technology during production. The PCBA1 soldering pad 9 is soldered with the soldering pad 7 above the PCB connector by using a tin solder 11, thereby forming an SMT (Surface Mounting Technology) assembly. A PCBA2 soldering pad 10 is arranged on the top of the PCBA2, the PCBA2 soldering pad 10 is fixed to the soldering pad 7 of the connector 2 by using the tin solder, and then the SMT assembly is mounted on the PCBA2 by means of the surface mounting technology. Finally, the PCBA1 and PCBA2 are communicated. The connector of the present invention enables the upper functional board and the lower functional board to be communicated through a copper material and via holes. The two functional boards are mounted on both sides of the connector by means of the surface mounting technology. In this way, the two PCBAs and the PCB connector located between them form an integral body. Through adopting this arrangement, a poor contact caused by vibration after the SMT process is effectively avoided.

Further, to match the shape of the functional boards, the PCB 5 is provided with a space 8 (e.g., a space formed by hollowing-out or slotting) for accommodating the elements on the functional boards.

More specifically, a PCB is a resin board coated with copper, which is a flat board without any elements. A functional board is an electronic assembly, which is a PCB soldered with elements.

A PCB is a printed circuit board, and a PCBAis a PCB soldered with elements, which is also called a functional board. After the two functional boards are connected, the functions can be integrally realized. For instance, a computer mainboard is the PCBA2, a display card is the PCBA1, and the memory module is also the PCBA1. The assembly can function only after the PCBA1 is inserted into the PCBA2. The connector is used to connect the functional boards PCBA1 and PCBA2.

A PCB having a certain structure or a PCB having pins and a customized shape can facilitate the design of the PCBA1. The pins of the PCB can be arranged into single-row, double-row or ring-shaped.

The size of the product depends on the size of the PCBA. To make the size of the product small, a small size of the PCBA is required or an irregular shape of the PCBA is required. Connectors are made of PCB materials and can be designed into any shapes using a PCB design software. The size of a connector can be the same as or smaller than the size of a PCB product, and the method for designing a connector is the same as the method for designing a PCB. The precision of the prepared connector is high. For instance, a circular PCBA is provided with a circular PCB connector. The pins on the PCB can be arranged into single-row, double-row, strip-shaped single-row or strip-shaped double-row.

The PCBs can be prepared into ring-shaped single-row connectors, strip-shaped single-row PCB connectors or strip-shaped double-row PCB connectors, and a PCBA can simultaneously match the three types of connectors. All PCB connectors are specially-matched connectors. Alternatively, the PCB connectors can be designed into a universal type. The pins of conventional board-to-board connectors can merely be arranged into single-row, double-row or strip-shaped, meaning that a customized shape needs a new mold. Thus, the production cost is sharply increased. In addition, a customized shape is normally not universal. The connector prepared by using the method of the present invention allows the elements to be arranged on both sides such that the cost is significantly lowered.

Additionally, by using the PCB connector of the present invention, a plurality of rows of pins are arranged on the upper and lower surfaces of the connector. Thus, the number of pins is increased without increasing the area of the connector. Compared with the present invention, at most two rows of pins are allowed to be arranged on a conventional board-to-board connector. When the number of pins is increased, the length of the connector is increased as well. If the number of pins is increased by using gold fingers along the connecting edge of the board or forming half holes at the edge of the board, the area of the PCBA is increased accordingly. Compared with conventional connectors, the number of pins of the connector provided by the present invention is unlimited, which can be prepared according to an actual situation. In this way, the problems caused by insufficient or excessive pins of a connector are effectively avoided. When the number of pins of a conventional gold finger connector is increased, the area of the connector is increased accordingly.

The preparation method for the connector of the present invention allows the elements to be arranged on both sides of the connector. Moreover, the height of the PCB connector can be customized such that the overall height of the product can be controlled. The height of the PCBs ranges from 0.5-5mm. Connectors with different heights can be made of materials with different heights. The conventional connectors with stamp holes do not allow elements to be arranged on both sides. The upper board is in direct contact with the lower board such that the contact surface does not allow any elements to be arranged. Through adopting the PCB connector of the present invention, the upper and lower PCBs are separated by the connector, and the upper PCBA allows elements to be arranged on both sides.

Further, the price of a PCB mainly depends on its area and number of layers. A conventional connector is normally a two-layered board with contact point soldering pads and a small area. The price of a high-speed connector is 10 or more times that of an ordinary connector. In addition, for conventional board-to-board connectors, two PCBAs are respectively soldered with one connector, and the communication is realized through the metal contact between the connectors. Because the transmission of high-speed signals has special requirements for the spacing and shape of material, the high-speed connectors are expensive. Moreover, PCBAs may have poor contact due to vibration after the SMT process. Normally, the pins are arranged into strip-shaped. When there are a large number of pins, a plurality of connectors are needed. The half-hole connection method does not need a connector, which allows the two PCBAs to be connected by means of the surface mounting technology. However, the parasitic parameters are large, the transmission speed and stability are not as good as that of a high-speed connector, the replacement and disassembly are difficult, and the number of pins is related to the length of four sides of the connector.

The present invention provides a connector using a PCB having a certain structure as a carrier. The shape of the connector can be customized according to the shape of the PCB to be connected. The pins of the connector can be arranged into any desired forms such as single-row, double-row or three-row. The number of pins is large and the occupied area is small. Through designing the soldering pads and the spacing, a stable high-speed signal transmission is achieved. Moreover, the elements can be arranged on both sides of the PCB instead of being wholly arranged on one side of the PCB. By means of this design, the size of the PCB is significantly reduced and the cost is greatly lowered. The production cost of the connector of the present invention is much lower than that of a conventional connector.

The present invention also provides a PCB connector using the connector prepared through adopting the preparation method of the present invention, wherein the connector is a board-to-board connector.

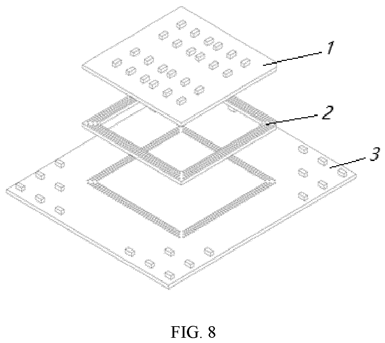

As shown in Figure 8, the present invention also provides an electronic device comprising a first functional board (PCBA1), a second functional board (PCBA2) and the connector provided by the present invention. The soldering pads on both sides of the connector are respectively connected with the soldering pad of the first functional board and the soldering pad of the second functional board. The soldering pads on both sides of the connector can be respectively connected with the soldering pad of the first functional board and the soldering pad of the second functional board by means of the surface mounting technology.

More specifically, a PCBA1 soldering pad 9 is arranged at the bottom of the PCBA1, and the connector 2 is mounted on the PCBA1 by means of the surface mounting technology during production. The PCBA1 soldering pad 9 is soldered with the soldering pad 7 above the PCB connector by using a tin solder 11, thereby forming an SMT (Surface Mounting Technology) assembly. A PCBA2 soldering pad 10 is arranged on the top of the PCBA2, the PCBA2 soldering pad 10 is fixed to the soldering pad 7 of the connector 2 by using the tin solder, and then the SMT assembly is mounted on the PCBA2 by means of the surface mounting technology. Finally, the PCBA1 and PCBA2 are communicated. The connector of the present invention enables the upper functional board and the lower functional board to be communicated through a copper material and via holes. The two functional boards are mounted on both sides of the connector by means of the surface mounting technology. In this way, the two PCBAs and the PCB connector located between them form an integral body. Through adopting this arrangement, a poor contact caused by vibration after the SMT process is effectively avoided.

Those skilled in the art can realize that the units and algorithm steps of each example described in combination with the embodiments disclosed herein can be implemented in electronic hardware, computer software or a combination of both. To clearly illustrate the interchangeability of hardware and software, the composition and steps of each example have been generally described according to the functions in the above description. Whether these functions are performed in hardware or software depends on the specific application and design constraints of the technical solution. Those skilled in the art may use different methods to realize the described functions for each specific application, and thus such realization should not be considered to be beyond the scope of the present invention.

In the embodiments provided by the present invention, it should be understood that the disclosed systems and methods can be implemented in other ways. For instance, the system described in the above embodiment is merely for illustration purpose. For instance, the division of each unit is only a division of logical functions, and there can be another dividing method in actual implementation. For instance, a plurality of units or components can be combined or integrated into another system, or some features can be ignored or not executed.

The above embodiments are merely used to illustrate but not to limit the technical solution of the present invention. Although the present invention has been described in detail combined with the above embodiments, those skilled in the art should understand that the technical solutions recorded in the above embodiments can be modified or some of the technical features can be equally replaced. These modifications or equal replacements do not separate the essence of the corresponding technical solution from the spirit and scope of the technical solution of each embodiment of the present invention.

## Claims

1. A preparation method for a connector, **characterized by** comprising the steps of:
Preparing a PCB (Printed Circuit Board) having a shape matched with the shape and structure of functional boards needing to be connected, and forming via holes in the PCB, wherein the via holes correspond to the positions of soldering pads of the functional boards;
Preparing soldering pads for connecting the functional boards on the PCB, wherein the soldering pads are arranged in the via holes for communicating the functional boards on both sides of the PCB.

2. The preparation method for a connector of claim 1, wherein preparing a PCB having a shape matched with the shape and structure of the functional boards needing to be connected, comprising: hollowing-out a PCB, thereby allowing the PCB to match or accommodate the elements on the functional boards.

3. The preparation method for a connector of claim 1, wherein the preparation method further comprising: using a PCB design software to simulate the parametric model of a PCB and then prepare a real PCB.

4. An application of a PCB connector **characterized by** using the connector prepared through adopting the preparation method of claims 1-2.

5. The application of claim 4, wherein the connector is a board-to-board connector.

6. A PCB connector, **characterized by** comprising:
a connector main body, wherein the connector main body is a PCB, wherein a plurality of via holes are formed in the PCB, soldering pads are arranged in the via holes, and the soldering pads are used for communicating the two functional boards.

7. The connector of claim 6, wherein the PCB is provided with a space for accommodating the elements on the functional boards.

8. An electronic device, comprising:
a first functional board,
a second functional board, and **characterized by** further comprising the connector of claims 6-7, wherein the soldering pads on both sides of the connector are respectively connected with the soldering pad of the first functional board and the soldering pad of the second functional board.

9. The electronic device of claim 8, wherein the soldering pads on both sides of the connector are respectively connected with the soldering pad of the first functional board and the soldering pad of the second functional board by means of the surface mounting technology.

10. A preparation method for a connector, **characterized by** comprising: preparing a PCB having a desired shape, and forming via holes in the PCB; preparing soldering pads for connecting the functional boards on the PCB, wherein the soldering pads are arranged in the via holes for communicating two functional boards.
